(19) 

**Europäisches Patentamt**
**European Patent Office**
**Office européen des brevets**

(11) **EP 4 325 388 B1**

(12) **EUROPEAN PATENT SPECIFICATION**

(45) Date of publication and mention
of the grant of the patent:
**05.06.2024   Bulletin 2024/23**

(51) International Patent Classification (IPC):
*G06F 30/10* (2020.01)      *G06N 3/08* (2023.01)
*G06N 3/04* (2023.01)      *G06T 17/30* (2006.01)
*G06F 30/27* (2020.01)      *G06V 20/64* (2022.01)
*G06V 10/82* (2022.01)      *G06T 19/00* (2011.01)
*G06N 5/022* (2023.01)      *G06N 5/01* (2023.01)
*G06N 3/088* (2023.01)

(21) Application number: **22306233.2**

(22) Date of filing: **17.08.2022**

(52) Cooperative Patent Classification (CPC):
**G06T 19/00; G06F 30/10; G06F 30/27;**
**G06N 3/042; G06N 3/0464; G06N 5/01;**
**G06N 5/022; G06V 10/82; G06V 20/64;**
G06N 3/045; G06N 3/088; G06N 3/0895;
G06N 20/10

(54) **MACHINE-LEARNING FOR TOPOLOGICALLY-AWARE CAD RETRIEVAL**

MASCHINELLES LERNEN FÜR TOPOLOGISCH BEWUSSTE CAD-WIEDERAUFFINDUNG

APPRENTISSAGE AUTOMATIQUE POUR RÉCUPÉRATION DE CAO TOPOLOGIQUEMENT
SENSIBLE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**21.02.2024   Bulletin 2024/08**

(60) Divisional application:
**24150188.1 / 4 339 826**

(73) Proprietor: **Dassault Systèmes**
**78140 Vélizy-Villacoublay (FR)**

(72) Inventors:
• **Mezghanni, Mariem**
**Vélizy-Villacoublay (FR)**
• **Boucher, Julien**
**Vélizy-Villacoublay (FR)**

• **Sabathier, Rémy**
**Vélizy-Villacoublay (FR)**

(74) Representative: **Bandpay & Greuter**
**11 rue Christophe Colomb**
**75008 Paris (FR)**

(56) References cited:
• **JAYARAMAN PRADEEP KUMAR ET AL: "UV-Net:**
**Learning from Boundary Representations", 2021**
**IEEE/CVF CONFERENCE ON COMPUTER VISION**
**AND PATTERN RECOGNITION (CVPR), IEEE, 20**
**June 2021 (2021-06-20), pages 11698-11707,**
**XP034009257, DOI:**
**10.1109/CVPR46437.2021.01153 [retrieved on**
**2021-10-15]**
• **THOMAS FUNKHOUSER ET AL: "Shape-based**
**retrieval and analysis of 3D models", 20040808;**
**1077952576 - 1077952576, 8 August 2004**
**(2004-08-08), pages 16-es, XP058167702, DOI:**
**10.1145/1103900.1103916**

## Description

### TECHNICAL FIELD

The disclosure relates to the field of computer programs and systems, and more specifically to a method, system and program of machine-learning.

### BACKGROUND

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service. <Insert page 1a>

Within this context and other contexts, there is a need for improved solutions for CAD object retrieval and similarity evaluation between CAD objects.

### SUMMARY

The appended claims define the scope of protection. Any examples and technical descriptions of apparatuses, products and/or methods in the description and/or drawings not covered by the claims are presented not as embodiments of the invention but as background art or examples useful for understanding the invention.

Also known is P. K. Jayaraman et. al., "UV-Net: Learning from Boundary Representations", 2021 IEEE/CVF Conference on Computer Vision and Pattern Recognition (CVPR). This document discloses a synthetic labelled B-rep dataset, SolidLetters, derived from human designed fonts with variations in both geometry and topology.

Also known is T. Funkhouser et. al. "Shape-Based Retrieval and Analysis of 3D Models", 2004, DOI: 10.1145/1103900.1103916. This document discloses a course that covers concepts, methods, and applications for retrieving and analyzing 3D models in large databases. Emphasis is placed on geometric representations and algorithms for indexing and matching 3D objects based on their shapes. A survey of current shape descriptors, query interfaces, and shape-based retrieval applications is included.

### BRIEF DESCRIPTION OF THE DRAWINGS

Non-limiting examples will now be described in reference to the accompanying drawings, where:

- FIG.s 1 to 13 illustrate the methods;

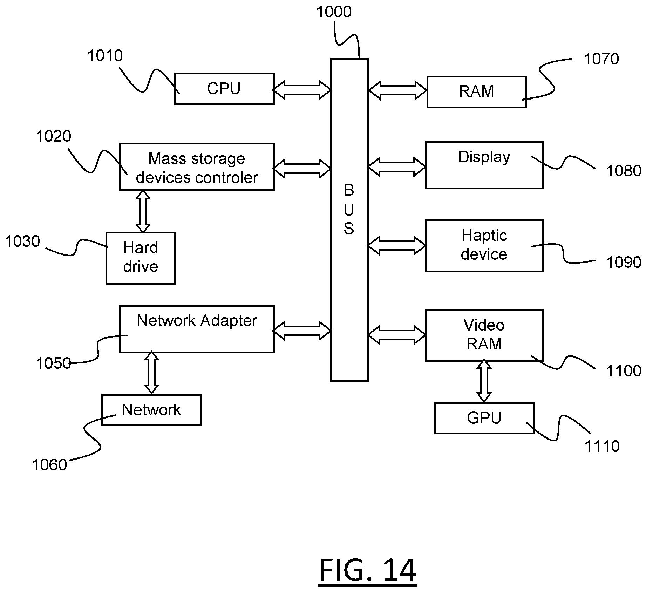

- FIG. 14 shows an example of the system.

### DETAILED DESCRIPTION

It is proposed a computer-implemented method of machine-learning. The method comprises obtaining a training dataset of B-rep graphs. Each B-rep graph represents a respective B-rep. Each B-rep graph comprises graph nodes each representing an edge, a face or a co-edge of the respective B-rep and being associated with one or more geometrical and/or topological features. Each B-rep graph comprises graph edges each between a respective first graph node representing a respective co-edge and a respective second graph node representing a face, an edge, an adjacent co-edge, or a mating co-edge associated with the respective co-edge. The method further comprises learning, based on the training dataset, a Deep CAD neural network. The Deep CAD neural network is configured to take as input a B-rep graph and to output a topological signature of the B-rep represented by the input B-rep graph. The method may be referred to as "the learning method".

The learning method forms an improved solution for CAD object retrieval.

Notably, the learning method learns a Deep CAD neural network configured to take as input a B-rep graph, that is a graph capturing the topology of a B-rep model (*i.e.* boundary representation model) of a product, and to compute a topological signature of the B-rep. The topological signature of the B-rep is a vector outputted by the Deep CAD neural network further to the processing of the input B-rep graph by the neural network's layers, and thereby forms a vector representation of the input B-rep graph. Now, such a vector is obtained by the Deep CAD neural network's layers processing the input B-rep graph. Such a graph represents both the geometry and the topology of a B-rep, as it comprises graph nodes representing the elements of the B-rep (edge, face, co-edge) and graph edges representing the topological relationships between the elements represented by the nodes connected by the edges. The graph also comprises topological and/or geometrical features of the underlying B-rep, that is feature vector encapsulating topological and/or geometrical information. The input B-rep graph is in other words a data structure that describes the geometry and topology of the B-rep, and the neural network learnt by the method takes such graph as input and extract thereof a B-rep topological signature (because the network is trained/learnt to do so). In other words, the learning method learns a neural network configured to encode a B-rep graph into a compact topological signature vector of the B-rep capturing the topology thereof.

The learning method may thereby be used for CAD object retrieval or similarity evaluation between CAD objects, or more generally for manipulation of CAD objects through the use of their topological signatures. In other words, the learnt Deep CAD neural network is usable for such tasks. Indeed, a CAD model or object is a feature-based object represented by a feature tree from which a B-rep representation of the model may be generated (*i.e.* by executing the feature tree). The neural network is trained to find the topological signature of such CAD model (*i.e.* specifically of a B-rep graph thereof), and thus allows manipulation of the CAD model through the use of its signature. The neural network may for example be used to find the signatures of two CAD models so as to compare them and to assess a topological similarity between them. This may for example be used for searching a CAD model in a CAD models database already comprising the topological signatures of the CAD models of the database: for a given CAD model of interest, the learnt neural network may be used to extract the topological signature of the CAD model and to query the database based on this signature. This allows the retrieval of the CAD model(s) of the database having the topological signature the closest to that of the given CAD model. Such retrieval may be used during CAD model design (*i.e.* design of a CAD model representing a manufacturing product, which may be manufactured downstream to the method) to carry out a fast replacement of a CAD model by a topologically similar one, as using the signature allows a fast query of the database and thus a fast and efficient retrieval of similar CAD models. The topological signature is indeed a representation of a CAD model that costs less, in terms of memory requirements (storage, memory footprint) and in terms of CPU resources during use/manipulation, than the corresponding B-rep model or graph, which makes the topological signature a computer object allowing for CPU-efficient and memory-efficient manipulation of CAD models. The signature may for example be a vector of relatively small dimension (for example 64), while yet providing good performances as the input B-rep graph is accurate topologically. The method is thereby in other words a machine-learning method for finding a compact topological vector representation of a given B-rep that is more efficient, in terms of memory and CPU, for manipulation, than the B-rep itself.

The learning method thus provides a framework to perform efficient and generic topological object retrieval of B-rep. Object retrieval refers to the task of which goal is to find effective and efficient similarity functions to allow searching, ranking and clustering of 3D object data for similarity. This is challenging since objects typically comprise many different geometries, structures, topologies and visual appearance properties, in addition to different material and functional properties. Furthermore, the notion of similarity may be domain-specific depending on the target task, it can be local, global, topological, geometric, and/or functional. Topological retrieval stands for object retrieval based on topological information similarity. Topological information provide the relationships among vertices, edges and faces. In addition to relationships, topological information also include orientation of edges and faces.

Furthermore, the method is based on a deep learning model that processes B-rep models without having to convert it to an approximate format (*e.g.* point cloud, mesh). The method uses a neural network to compute a signature from any given B-rep model. This signature is sensitive to the topology of the input B-rep model, such that two B-rep models with close topologies will have close signatures.

Moreover, the method provides:

- Time efficiency: the method allows for fast queries,
- Memory space efficiency: the method allows for CAD retrieval by relying on computing signatures for B-rep models, and the signatures are light in term of memory space requirements;
- Data-driven method: the method allows to leverage unlabeled B-rep datasets on which to learn; and
- A deep learning method on the B-rep graph for automatic topologically-aware retrieval. The advantage of working directly on such a format is to avoid any loss of geometrical information (due to approximation) or topological information discarding.

The learning method is for machine learning.

As known per se from the field of machine-learning, the processing of an input by a neural network includes applying operations to the input, the operations being defined by data including weight values. Learning a neural network thus includes determining values of the weights based on a dataset configured for such learning, such a dataset being possibly referred to as a learning dataset or a training dataset. For that, the dataset includes data pieces each forming a respective training sample. The training samples represent the diversity of the situations where the neural network is to be used after being learnt. Any training dataset herein may comprise a number of training samples higher than 1000, 10000, 100000, or 1000000. In the context of the present disclosure, by "learning a neural network based on a dataset", it is meant that the dataset is a learning/training dataset of the neural network, based on which the values of the weights (also referred to as "parameters") are set.

In the context of the learning method, the training dataset is the provided dataset of B-rep graphs, which is now discussed. Prior to the discussion on the providing of the dataset, data structures involved therein are now discussed.

"B-rep", also referred to as "BRep", stands for "Boundary Representation". B-rep is, in CAD applications, the most common type of modeling. B-rep is a mathematically precise representation of a 3D object. This representation defines a solid as a collection of connected surface elements, which define the boundary between interior and exterior points. There are two types of information in a B-rep: topological components and geometric definitions for those components. Topological components comprises vertices, edges and faces defining 3D object surface, and the connections between them. In addition to connectivity, topological information also include orientation of edges and face, while, geometric information consists usually of mathematical equations describing vertices, edges and faces (points, curves and surfaces respectively).

The B-rep (i.e. boundary representation) is a 3D representation of a mechanical part. Specifically, the B-rep is a persistent data representation describing the 3D modeled object representing the mechanical part. The B-rep may be the result of computations and/or a series of operations carried out during a designing phase of the 3D modeled object representing the mechanical part. The shape of the mechanical part displayed on the screen of the computer when the modeled object is represented is (e.g. a tessellation of) the B-rep. In examples, the B-rep represents a part of the model object.

A B-Rep includes topological entities and geometrical entities. Topological entities are: face, edge, and vertex. Geometrical entities are 3D objects: surface, plane, curve, line, point. By definition, a face is a bounded portion of a surface, named the supporting surface. An edge is a bounded portion of a curve, named the supporting curve. A vertex is a point in 3D space. They are related to each other as follows. The bounded portion of a curve is defined by two points (the vertices) lying on the curve. The bounded portion of a surface is defined by its boundary, this boundary being a set of edges lying on the surface. The boundary of the edges of the face are connected by sharing vertices. Faces are connected by sharing edges. Two faces are adjacent if they share an edge. Similarly, two edges are adjacent if they share a vertex. In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open is it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic or other analysis, it supports local refinement of the simulation meshes to capture physical phenomena, and for kinematics it supports true contact modeling between curved surfaces. Finally, a B-Rep allows a small memory and/or file footprint. First, because the representation contains surfaces based only on parameters. In other representations such as meshes, the equivalent surface comprises up to thousands of triangles. Second, because a B-Rep doesn't contain any history-based information.

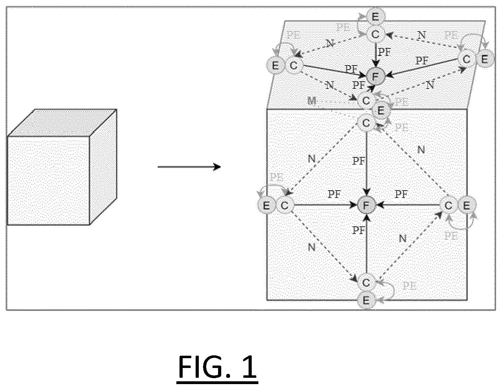

Besides vertices, faces and edges, each B-rep herein also comprises co-edges. A co-edge is an oriented edge, *i.e.* an edge of the B-rep with additional orientation information. The co-edges thereby define an ordering around the B-rep faces and the faces adjacency, *i.e.* they define the topology of the B-rep. The co-edges link the B-rep entities altogether. Each co-edge has one parent face (*i.e.* the face for which it defines a bound), one parent edge, (*i.e.* by definition a co-edge is an oriented edge and thus has a parent edge), one mate co-edge which is the co-edge having the same parent edge, one next co-edge, corresponding to the next co-edge in the loop where the co-edge belongs, and one previous co-edge, corresponding to the previous co-edge in the loop where the co-edge belongs. Each co-edge maintains an adjacency relationship with the next and previous co-edge around its parent face, the mating co-edge on the adjacent face, the parent face and the parent edge. FIG. 1 illustrates an example of co-edge interactions with other entities for two faces of a cube (F: Face, E: Edge, C: co-edge, N: Next interaction, M: Mate Interaction, PF: Parent Face, PE: Parent Edge).

Each B-rep graph herein is a graph representation of a respective B-rep, and comprises graph nodes and graph edges. Each graph node represents a respective edge, a respective face or a respective co-edge of the respective B-rep. This means that for each edge of the B-rep, there is a respective graph node, for each face of the B-rep, there is a respective graph node, and for each co-edge of the B-rep, there is a respective graph node. Each graph node further comprises a geometrical and/or topological feature associated with (*i.e.* attached to) the graph nodes. The feature is data, for example a vector (also referred to as feature vector), associated with the node and describing geometrical data and/or topological data characterizing the B-rep element represented by the graph nodes. Table 1 below shows, for each B-rep-entity (edge, co-edge or face), the list of names of the geometrical and/or topological elements comprised in the feature vector attached to the corresponding graph nodes according to examples of the method, with for each geometrical and/or topological element a description of the element. The numbers between parentheses indicate the dimension of the corresponding vector.

*Table 1 : example of geometrical and/or topological feature vector*

| Entity | Name | Description |
|---|---|---|
| Edge (15) | Type of Geometry (5) | One-hot vector indicating the type of Edge (Line, Circle, Ellipse, B-Spline, Intersection Curve) |
| | Close Loop (1) | Boolean set to True if the Edge bounds a Face on its own |
| | Line Length (1) | Length of the Line (0 if not a Line) |
| | Circle Radius (1) | Radius of the circle edge (0 if not a circle) |
| | Ellipse Axis (2) | Semi-major and Semi-minor Ellipse axis (0 if not an Ellipse) |
| | Plane-to-Plane convexity (3) | In the case of an Edge between two Planes, indicates if the Edge is concave or convex |
| | B-Spline degree & Control Points (2) | If the Edge is a B-Spline, the degree and the number of control points that controls the B-Spline |
| Coedge (1) | Direction Flag (1) | Indicates if the coedge has the same orientation that its parent Edge |
| Face (8) | Kind of geometry (5) | One-hot vector indicating the type of Face (Plane, Sphere, Cylinder, There, B-Spline) |
| | B-Spline degrees & Control Points (3) | If the Face is a B-Spline, the degree (in both parametric dimension u and v) and the number of control points |

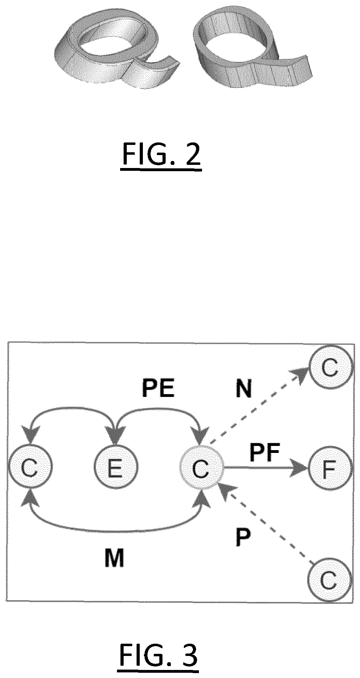

The features in the above example illustrated by Table 1 are invariant to rotation and translation of the CAD model. FIG. 2 illustrates the disentanglement of geometric and topological features, showing two B-rep models that are geometrically very similar, while being topologically very different.

The graph also comprises graph edges. Each respective graph edge connects two respective graph nodes, a respective first node and a respective second node. The first graph node represents a respective co-edge. The second graph node represents one of:

- a face associated with the respective co-edge (*i.e.* the parent face of the co-edge, that is the face for which it defines a bound),
- an edge (*i.e.* the parent edge of the co-edge),
- an adjacent co-edge (*i.e.* the next or previous co-edge, that is the next or previous co-edge in the loop where the co-edge belongs), or
- a mating co-edge (*i.e.* the co-edge having the same parent edge).

Obtaining the training dataset may comprise creating the training dataset, that is creating or generating the B-rep graphs. Creating/generating the B-rep graphs may comprise:

- obtaining (*e.g.* retrieving or downloading from a (*e.g.* distant) memory or server or B-rep database) B-reps encoded as B-rep files (*e.g.* of already designed CAD models), which may be STEP files;
- converting (by any known method) the B-rep files into initial B-rep graphs where the graph nodes are the topological components of the B-rep and the edges represent the interactions between them;
- extracting geometric parameters from the B-rep files and computing the topological and/or geometrical features; and
- integrating the computed features to the initial B-rep graphs, thereby forming the B-rep graphs of the training dataset.

Obtaining the training dataset may alternatively comprise retrieving or downloading from a (*e.g.* distant) memory or server or database the B-rep graphs.

Further to the obtaining of the training dataset, the method then comprises the learning of the Deep CAD neural network based on the training dataset. Learning means that the method feeds B-rep graphs of the training dataset as input to the neural network and modifies the weights of the neural network as long as the neural network does not output sufficiently satisfactory outputs (*e.g.* with respect to a suitable convergence criterion, *e.g.* with respect to a loss optimization). The output of the neural network, for an input B-rep graph, is a topological signature of the B-rep represented by the B-rep graph. The topological signature is an embedding vector that the neural network outputs for the input B-rep and that captures the topology of the underlying B-rep.

The Deep CAD neural network is a Deep Neural Network, also referred to as DNN. DNNs are a powerful set of techniques for learning in Neural Networks which is a biologically-inspired programming paradigm enabling a computer to learn from observational data. In object recognition, the success of DNNs is attributed to their ability to learn rich midlevel media representations as opposed to hand-designed low-level features (Zernike moments, HOG, Bag-of-Words, SIFT, etc.) used in other methods (min-cut, SVM, Boosting, Random Forest, etc.). More specifically, DNNs are focused on end-to-end learning based on raw data. In other words, they move away from feature engineering to a maximal extent possible, by accomplishing an end-to-end optimization starting with raw features and ending in labels. DNN's are discussed in reference D. E. Rumelhart, G. E. Hinton, R. J. Williams, "Learning internal representations by error propagation, Parallel distributed processing: explorations in the microstructure of cognition", vol. 1: foundations, MIT Press, Cambridge, MA, 1986.

The Deep CAD neural network may have an architecture of a classical graph convolutional network, as discussed for example in reference T. N. Kipf and M. Welling, *"Semi-Supervised Classification with Graph Convolutional Networks"*, 2016. Such an architecture is particularly adapted since the input data of the Deep CAD neural network is a graph. The standard objective of such models is to compute an embedding vector for each node of the graph. These models are usually based on message passing: in order to compute an embedding vector to describe the node of the graph, each node will gather the previous feature vector from its neighborhood and pass it to a deep learning network. The Deep CAD neural network architecture may specifically be that proposed in reference J. G. Lambourne, K. D. Willis, P. K. Jayaraman, A. Sanghi, P. Meltzer and H. Shayani, *"BRepNet: A topological message passing system for solid models"* CVPR 2021,: a deep learning model based on the same principles as classical graph convolutional network (as discussed in previously-cited reference T. N. Kipf and M. Welling, "Semi-Supervised Classification with Graph Convolutional Networks", 2016), but with a message passing based on the topological interaction of co-edges.

The Deep CAD neural network may comprise a convolution unit, which is a layer of the neural network in which the message passing occurs. The convolution unit is configured to perform a kernel concatenation. The kernel concatenation concatenates a feature vector of each co-edge with the feature vectors of its neighboring B-rep elements according to a kernel of the neural network. As known *per se* in the field of Machine-Learning, the kernel is a specified walk according to which the neural network concatenates the features of the input, the features being here the topological and/or geometrical features. The kernel concatenates the feature of each co-edge with the features of its neighborhood according to this walk. The kernel walk may be a combination of the five following elementary walk operations: next co-edge, previous co-edge, mate co-edge, parent face, and parent edge. FIG. 3 illustrates these operations (PE: parent edge, PF: parent face, N: next, P: previous, M: mate, C: co-edge, E: edge, F: face). The last two walk operations are terminative since they end up on an entity that is not a co-edge. The kernel may be {*I, N, P, M, PE, PF*}, *i.e.* each co-edge will concatenate its current feature vector with the current feature vector of the next co-edge, the previous co-edge, the mate co-edge, the parent edge and the parent face, resulting in the following concatenated feature vector (for each co-edge c):

$$\phi_c^{(i)} = \left[ X_c^{(i)} \middle| X_N^{(i)} \middle| X_P^{(i)} \middle| X_M^{(i)} \middle| X_{PE}^{(i)} \middle| X_{PF}^{(i)} \middle| \right]$$

where $X_k^{(i)}$ is the feature vector of the entity $k$ at the step $i$.

The convolution unit may be further configured to pass each concatenated feature vector of a co-edge resulting from the kernel concatenation as input to a dense neural network. The dense neural network is a deep neural network which is a Multi-Layer Perception (MLP). The dense network may output (for each co-edge c):

$$\psi_c^{(i)} = MLP\left(\phi_c^{(i)}\right) = [\, \psi_{CC}^{(i)} \big| \psi_{CF}^{(i)} \big| \psi_{CE}^{(i)} \,]$$

where $\psi_{CC}^{(i)}, \psi_{CF}^{(i)}, \psi_{CE}^{(i)}$ have the same dimension h such that the dimension of $\psi_c^{(i)}$ is 3*h.

The convolution unit may be further configured to compute, for each vector outputted by the dense neural network for an input concatenated feature vector of a co-edge, a new edge feature vector, a new face feature vector, and a new co-edge feature vector. For example, the dense neural network may output, for an input concatenated feature vector $\phi_c^{(i)}$ of a co-edge $c$ resulting from the kernel concatenation:

$$\psi_c^{(i)} = MLP\left(\phi_c^{(i)}\right) = \left[\, \psi_{CC}^{(i)} \big| \psi_{CF}^{(i)} \big| \psi_{CE}^{(i)} \,\right],$$

where $\psi_{CC}^{(i)}, \psi_{CF}^{(i)}, \psi_{CE}^{(i)}$ have the same dimension h such that the dimension of $\psi_c^{(i)}$ is 3*h. Then the new feature vectors for each co-edge $c$, each face $F$, and each edge $E$, may be

$$\begin{cases} X_c^{(i+1)} = \psi_{CC}^{(i)} \\ X_E^{(i+1)} = MaxPool(\, \psi_{CE1}^{(i)}, \, \psi_{CE2}^{(i)}) \\ X_F^{(i+1)} = MaxPool(\, \psi_{CF1}^{(i)}, \dots, \, \psi_{CFk}^{(i)}) \end{cases}$$

where:

- $X_c^{(i+1)}$ is the computed new co-edge feature for the output $\psi_c^{(i)}$ of the dense neural network for co-edge c;
- $X_E^{(i+1)}$ is the computed new edge feature for edge E where $\psi_{CE1}^{(i)}$ and $\psi_{CE2}^{(i)}$ correspond to the feature vectors of its two associated co-edges ;
- $X_F^{(i+1)}$ is the computed new face feature for face F where $\psi_{CF1}^{(i)}, \dots, \psi_{CFk}^{(i)}$ correspond to the features of its $k$ associated co-edges.

The computation of the new feature vectors may be referred to as "Entity Pooling" since this computation pools the feature vectors previously computed (*i.e.* at the co-edge level) to obtain the new features of the face and edge entities. The fact that this computation separates the intermediate vectors used for pooling by entities helps the learnt neural network to learn specific features for each type of entity.

At the end of the convolution unit, the output may thereby be still a graph, with a new feature vector attached to each entity. The Deep CAD neural network may be configured to apply the convolution unit repeatedly a predetermined number of times, for example at least three times, for example three times. The method may in other words stack several convolutional units one after another. Just like stacking convolutional layers in computer vision increase the receptive field of the model, stacking the convolutional unit helps each co-edge to see a larger portion of its neighborhood and can thus help to capture more global and/or complex features.

The Deep CAD neural network may be further configured to compute global feature vectors by performing an aggregation of face feature vectors that result from the convolution unit application(s). This computation is referred to as "global pooling". This computation of global feature vectors allows to fulfill the objective of the Deep CAD neural network to return a single signature for an input CAD model, as it allows generating a single embedding from a graph where each node entity has an embedding vector. The global pooling only aggregates the face features, which is sufficient because each face is connected in the B-rep graph to a set of co-edges. As such, they gather thereby more information on their local neighborhood than edges or co-edges.

The aggregation may be based on a Max Pooling method/strategy, *i.e.* the aggregation may use a Max Pooling strategy/method over the faces. The Max Pooling may be implemented as follows. Let $Z_g$ be the embedding of the global input B-rep-graph, $Z_F^{(k)}$ the embedding of the face (k) output by the last convolutional layer of the Deep CAD neural network. Then the Max Pooling may consist in computing $Z_g$ as follows:

$$Z_F^{(k)} \epsilon \ \mathbb{R}^h$$

$$Z_g = MaxPool\left(Z_F^{(1)}, Z_F^{(2)}, ..., Z_F^{(K)}\right) \epsilon \ \mathbb{R}^h$$

where *h* is the dimension of the face embedding.

Alternatively, the aggregation may be based on an Attention Mechanism method. Such method is discussed in reference M. Ilse, J. M. Tomczak and M. Welling, "Attention-based Deep Multiple Instance Learning", 2018

This alternative aggregation strategy introduces an additional learning module in the model. The pooling is in this case a weighted average of the face embeddings ( $Z_F^{(1)}, ..., Z_F^{(K)}$ ):

$$Z_g = \sum_{k=1}^{K} a_k \, Z_F^{(k)}$$

The weights ($a_1, ... , a_K$) are computed by a neural network, with

$$a_k = \frac{e^{w^T \tanh (V \ Z_F^{(k)^T})}}{\sum_{i=1}^{K} e^{w^T \tanh (V \ Z_F^{(i)^T})}}$$

where $W \epsilon \mathbb{R}^{hx1}, V \epsilon \mathbb{R}^{hxh}$ are learnt parameters.

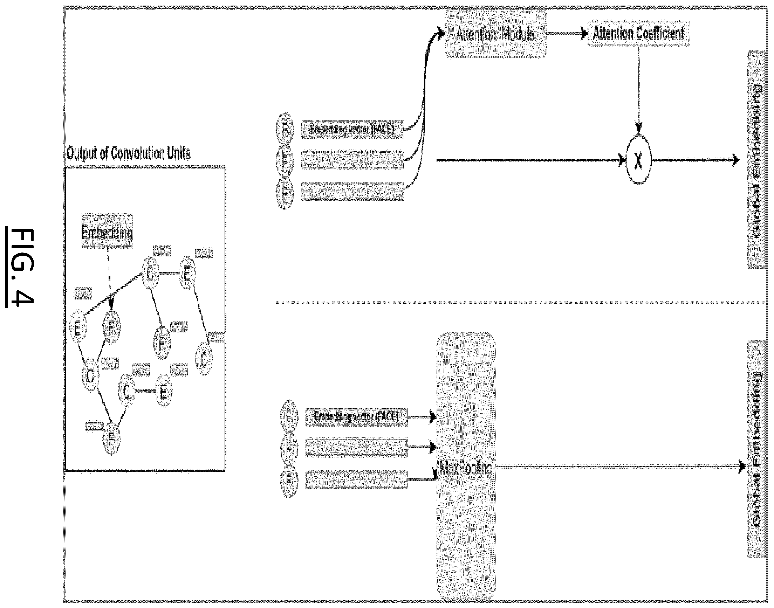

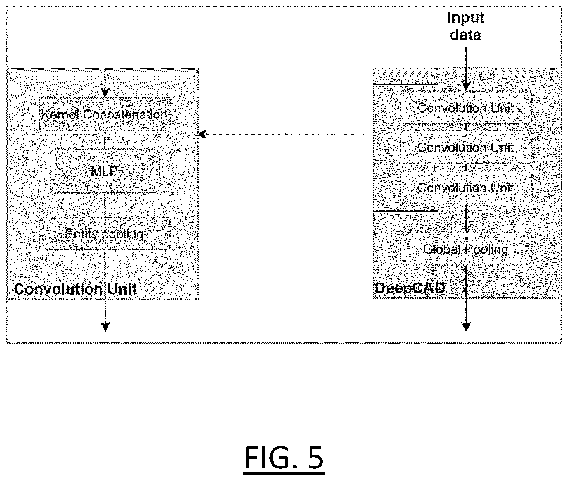

Both strategies allows to handle the challenge that inputs can have completely different number of nodes or edges. FIG. 4 illustrates the two strategies (F: Face, C: co-edge, E: Edge). FIG. 5 shows an example of a global architecture of the Deep CAD neural network, where three convolution units are applied successively before the global pooling is performed. Each convolution unit performs the kernel concatenation, the application of the Multi-Layer Perceptron (MLP) and the entity pooling.

The learning of the Deep CAD neural network may comprise performing a contrastive learning to train the Deep CAD neural network to compute a topological signature of a global feature vector. The constative learning allows to handle the case where B-Rep graphs, or the B-rep models form which the graphs stem, are unlabelled. The concept of contrastive learning is known from reference T. Chen, S. Kornblith, M. Norouzi and G. E. Hinton, "A Simple Framework for Contrastive Learning of Visual Representations" 2020, and is adapted for being implemented in the method.

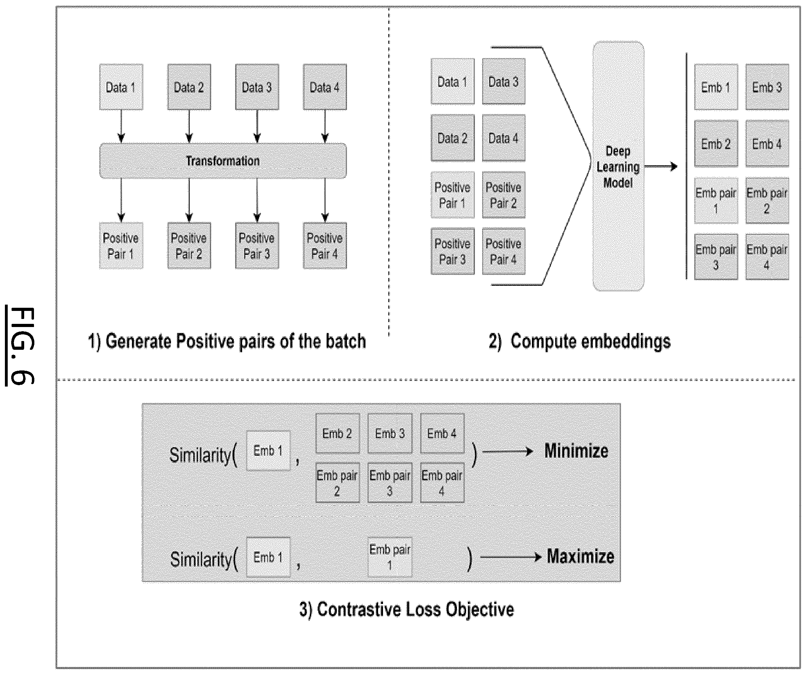

In the original paper (T. Chen, S. Kornblith, M. Norouzi and G. E. Hinton, "A Simple Framework for Contrastive Learning of Visual Representations" 2020), the framework proposes to learn embeddings of images in an unsupervised way using the contrastive learning paradigm as illustrated in FIG. 6. The goal is to learn expressive latent representations of the training data such as two similar inputs (positive pair) that have close embedding vectors and different outputs (negative pair) that have distant embedding vectors. However, if the training data is unlabeled, positive and negative pairs are not initially accessible. Contrastive learning paradigm sidesteps this limitation by synthetically creating these pairs via data augmentation techniques. Specifically, each input data undergoes random transformation as illustrated on FIG. 6 (step 1)), so that two transformations of the same input constitute a positive pair and a negative pair otherwise. For instance, for their application on image datasets, classical image transformations such as random color shifting and random cropping may be chosen.

The contrastive learning of the present method may be based on positive transformations that include:

- the identity transformation,
- assign a random geometry to an edge with a probability p (*e.g.* a Line becomes an ellipse),
- assign a random geometry to a face with a probability p (*e.g.* a Plane becomes a Cylindrical Surface),
- replace the feature vector of a face with zeros with a probability p, and
- delete an edge with a probability p, this deletion being not applied if it disconnects a face from the input B-rep graph.

In other words, these transformations may be the transformations used for generating the pairs of the constative learning framework. This allows to implement the contrastive learning framework for the specific inputs considered by the method (B-rep graphs, possible unlabelled), as these positive transformations are adapted to the specific input data type. All transformations preserve the graph topology, which leads the learned network to capture topological similarity.

The contrastive learning may comprise minimizing a normalized temperature-scaled cross entropy loss that is based on the cosine similarity, the loss being of the type:

$$L(i,j) = -\log\frac{e^{sim(Z_i,Z_j)}}{\sum_{k=1}^{2N} 1_{[k\neq i]} \, e^{sim(Z_i,Z_k)}},$$

where (*i, j*) represents a positive pair and (*Z_i, Z_j*) represents an embedding of the positive pair by the Deep CAD neural network, and where *sim* is the cosine similarity defined by the formula:

$$sim(x,y) = \frac{x.y}{\|x\|\|y\|} = \frac{\sum_{i=1}^{h} x_i y_i}{\sqrt{\sum_{i=1}^{h} x_i^2}\sqrt{\sum_{i=1}^{h} y_i^2}},$$

for $x,y \in \mathbb{R}^h$. The loss is used on a mini-batch by mini-batch training where N is the mini-batch size. The augmented batch (with the pairs) has thus 2N elements. The augmented batch is passed to the Deep CAD neural network to compute embeddings (as in step 2) of FIG. 6). The objective of the neural network (as illustrated on FIG. 6 step 3)) is to maximize the similarity between the embedding and its positive pair, and minimize the similarity between the other 2(N-1) embeddings. The similarity function is the cosine similarity. In the above formula, (*i, j*) represents a positive pair in the augmented batch of size 2N.

It is further provided a neural network learnable according to the method, that is a computer-implemented neural network data structure having the weights of a neural network learnt by the method. The provided neural network may for example have been learnt directly by the method, with its weights having been fixed by the learning step of the method.

It is further provided a method of use of the neural network. The method of use comprises obtaining a B-rep graph representing a B-rep. The method of use further comprises applying the neural network to the B-rep graph, thereby obtaining a topological signature of the B-rep.

The method of use may be for similarity search between CAD models and for CAD object retrieval. Indeed, the learnt neural network generates topological signatures from input B-Reps (CAD) objects. These signatures embed topological information. As such, topologically similar CAD models (B-reps) have or tend to have a high signature similarity.

The method of use may be for topological similarity search between two CAD models. In this case, the method of use may comprise:

- providing a first B-rep graph of a first B-rep and a second B-rep graph of a second B-rep;
- applying the neural network to the first B-rep graph and to the second B-rep graph, thereby obtaining a first topological signature of the first B-rep and a second topological signature of the second B-rep; and
- evaluating the similarity between the two signatures.

The method of use may be for CAD object retrieval in a database through topological similarity search. In this case, the method of use may comprise:

- providing:

  o a given B-rep graph of a given B-rep;
  o a database of B-reps and/or CAD models associated to these B-reps, each B-rep and/or CAD model in the database being associated with its topological signature (*i.e.* which is already computed, *e.g.* which has been previously computed by using the neural network)

- applying the neural network to the given B-rep graph, thereby obtaining a signature of the given B-rep;
- querying the database with the signature of the given B-rep; and
- for each B-rep and/or CAD model of the database, evaluating the similarity between the signature of the given B-rep and the signature of the B-rep and/or CAD model of the database.

In all above examples of the method of use, providing a B-rep graph of a B-rep may comprise generating the B-rep graph as discussed hereinabove for the providing of the training dataset in the learning method. Providing the database may comprise obtaining the topological signatures of at least some (*e.g.* all) of the models in the database, by applying the Deep CAD neural network to these models' B-rep graphs (which the providing of the database may comprise generating). Evaluating the similarity between a signature and another signature may comprise computing the cosine similarity between the two signatures. The cosine similarity between two signature vectors *x* and *y* is computed with the cosine similarity function:

$$sim(x, y) = \frac{x \cdot y}{\|x\|\|y\|} = \frac{\sum_{i=1}^{h} x_i y_i}{\sqrt{\sum_{i=1}^{h} x_i^2}\sqrt{\sum_{i=1}^{h} y_i^2}}.$$

Since computing the similarity between two signatures is extremely fast, the result can be given to a user in a very short amount of time.

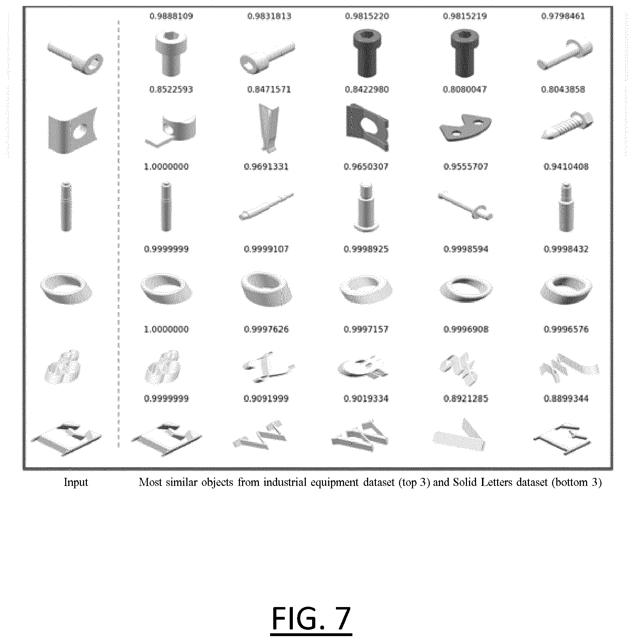

FIG. 7 shows example results obtained from the Deep CAD neural network trained on a database of 150k industrial equipment (screws, nut, knob, or the like), and tested on an industrial equipment dataset and on academic dataset Solid Letters of alphabetical upper letters (discussed in reference P. K. Jayaraman, A. Sanghi, J. G. Lambourne, K. D. Willis, T. Davies, H. Shayani and N. Morris, "UV-Net: Learning from Boundary Representations" CVPR 2021) displayed in the 3 top rows and 3 bottom rows respectively. The number on top of each object is the similarity with the input signature. FIG. 7 illustrates that the most similar object is the object itself when the latter belongs to the database. Compared to geometric retrieval discussed in previously-cited reference P. K. Jayaraman, A. Sanghi, J. G. Lambourne, K. D. Willis, T. Davies, H. Shayani and N. Morris, "UV-Net: Learning from Boundary Representations" CVPR 2021, where similar models belong to the same letter category, the topological retrieval rather extracts similar objects in terms of graph information (structure and element features).

The learning method and the method of use may be implemented in a same CAD object retrieval process which comprises first performing the learning method (this step may be referred to as "offline stage") and then performing the method of use (this step may be referred to as "online stage"). FIG.s 8 and 9 shows flowchart of examples of such process. The process examples are illustrated in these figures, with the offline and the online stages:

- Offline stage: this stage aims at training a model using manufacturing B-rep objects. This stage may be transparent from the user;

  o Training B-rep graph generation stands for implementing a conversion pipeline from raw B-rep training files to graphs where the nodes of the graph are all the topological components and the edges represent the interactions between them. The data parsing includes geometric parameter extraction and features computation for the different components;
  o Neural network model is learned based on the training B-rep graphs. It consists on a B-rep DNN-based model;

- Online stage: given a B-rep file and B-rep database, the data is first preprocessed to generate the corresponding B-rep graphs. Then, the trained model is applied to compute the signatures of input and database objects. Finally the most similar object is retrieved from the B-rep database to the Input B-rep in terms of signatures similarities (distances).

FIG.s 10 to 13 illustrate examples of the online stage. Each figure shows a query B-rep and the most topologically similar B-rep retrieved in the database. Each figure also shows the most geometrically similar B-rep, for illustrating the difference between geometrical vs topological retrieval.

The methods are computer-implemented. This means that steps (or substantially all the steps) of the methods are executed by at least one computer, or any system alike. Thus, steps of the methods are performed by the computer, possibly fully automatically, or, semi-automatically. In examples, the triggering of at least some of the steps of the methods may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

FIG. 14 shows an example of the system, wherein the system is a client computer system, *e.g.* a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the methods. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the methods to be performed on the cloud computing environment.

**Claims**

1. A computer-implemented method of machine-learning, the method comprising:

   - obtaining a training dataset of B-rep graphs, each B-rep graph representing a respective B-rep and comprising:

      o graph nodes each representing an edge, a face or a co-edge of the respective B-rep and being associated with one or more geometrical and/or topological features, where, for each node, the one or more geometrical and/or topological features form a feature vector attached to the node so that the one or more geometrical and/or topological features are also comprised in said each B-rep graph; and

o graph edges each between a respective first graph node representing a respective co-edge and a respective second graph node representing a face, an edge, an adjacent co-edge, or a mating co-edge associated with the respective co-edge; and

- learning, based on the training dataset, a Deep CAD neural network configured to take as input a B-rep graph and to output a topological signature of the B-rep represented by the input B-rep graph, the B-rep graph taken as input by the Deep CAD neural network comprising graph nodes each representing an edge, a face or a co-edge of the B-rep represented by the B-rep graph and being associated with one or more geometrical and/or topological features, where, for each node, the one or more geometrical and/or topological features form a feature vector attached to the node so that the one or more geometrical and/or topological features are also comprised in the B-rep graph taken as input by the Deep CAD neural network, the B-rep graph taken as input by the Deep CAD neural network also comprising graph edges each between a respective first graph node representing a respective co-edge and a respective second graph node representing a face, an edge, an adjacent co-edge, or a mating co-edge associated with the respective co-edge, the Deep CAD neural network being a deep neural network with a graph convolutional network architecture,

wherein B-rep means boundary representation and CAD means computer-aided-design.

2. The method of claim 1, wherein the Deep CAD neural network comprises a convolution unit that is configured to perform a kernel concatenation that concatenates the feature vector of each co-edge with the feature vectors of its neighboring B-rep elements according to a kernel of the neural network, the neighboring B-rep elements of the co-edge being its next co-edge, its previous co-edge, its mate co-edge, its parent edge, and its parent face.

3. The method of claim 2, wherein the convolution unit is further configured to pass each concatenated feature vector of a co-edge resulting from the kernel concatenation as input to a dense neural network.

4. The method of claim 3, wherein the convolution unit is further configured to compute, for each vector outputted by the dense neural network for an input concatenated feature vector of a co-edge, a new edge feature vector, a new face feature vector, and a new co-edge feature vector.

5. The method of claim 4, wherein the dense neural network outputs, for an input concatenated feature vector $\phi_c^{(i)}$ of a co-edge $c$ resulting from the kernel concatenation:

$$\psi_c^{(i)} = MLP\left(\phi_c^{(i)}\right) = \left[\, \psi_{CC}^{(i)} \middle| \psi_{CF}^{(i)} \middle| \psi_{CE}^{(i)} \,\right],$$

where $\psi_{CC}^{(i)}, \psi_{CF}^{(i)}, \psi_{CE}^{(i)}$ have the same dimension h such that the dimension of $\psi_c^{(i)}$ is 3*h, and wherein each co-edge $c$, each face $F$, and each edge $E$, the new feature vectors are,

$$\begin{cases} X_c^{(i+1)} = \psi_{CC}^{(i)} \\ X_E^{(i+1)} = MaxPool(\psi_{CE1}^{(i)}, \psi_{CE2}^{(i)}) \\ X_F^{(i+1)} = MaxPool(\psi_{CF1}^{(i)}, \dots, \psi_{CFk}^{(i)}) \end{cases}$$

where:

- $X_c^{(i+1)}$ is the computed new co-edge feature for the output $\psi_c^{(i)}$ of the dense neural network for co-edge c;
- $X_E^{(i+1)}$ is the computed new edge feature for edge $E$ where $\psi_{CE1}^{(i)}$ and $\psi_{CE2}^{(i)}$ correspond to the feature vectors of its two associated co-edges;
- $X_F^{(i+1)}$ is the computed new face feature for face $F$ where $\psi_{CF1}^{(i)}, \dots, \psi_{CFk}^{(i)}$ correspond to the features of its *k* associated co-edges.

6. The method of claims 2 or 5, wherein the Deep CAD neural network is configured to apply the convolution unit repeatedly a predetermined number of times.

7. The method of any one of claims 2 to 6, wherein the Deep CAD neural network is further configured to compute global feature vectors by performing an aggregation of face feature vectors, the aggregation being based on a Max Pooling method or on an Attention Mechanism method.

8. The method of claim 7, wherein the learning of the Deep CAD neural network comprises performing a contrastive learning to train the Deep CAD neural network to compute a topological signature of a global feature vector.

9. The method of claim 8, wherein the contrastive learning is based on positive transformations that include:

   - the identity transformation,
   - assign a random geometry to an edge with a probability,
   - assign a random geometry to a face with a probability,
   - replace the feature vector of a face with zeros with a probability,
   - delete an edge with a probability p, this deletion being not applied if it disconnects a face from the input B-rep graph.

10. The method of claim 8 or 9, wherein the contrastive learning comprises minimizing a normalized temperature-scaled cross entropy loss that is based on the cosine similarity, the loss being of the type:

$$L(i,j) = -\log \frac{e^{sim(z_i, z_j)}}{\sum_{k=1}^{2N} 1_{[k \neq i]} e^{sim(z_i, z_k)}},$$

where $(i, j)$ represents a positive pair and $(Z_i, Z_j)$ represents an embedding of the positive pair by the Deep CAD neural network, and where *sim* is the cosine similarity defined by the formula:

$$sim(x,y) = \frac{x.y}{\|x\|\|y\|} = \frac{\sum_{i=1}^{h} x_i y_i}{\sqrt{\sum_{i=1}^{h} x_i^2} \sqrt{\sum_{i=1}^{h} y_i^2}},$$

for $x, y \in \mathbb{R}^h$.

11. The method of any one of claims 1 to 10, wherein the method further comprises using the learnt Deep CAD neural network, wherein using the learnt Deep CAD neural network comprises:

   - obtaining a B-rep graph representing a B-rep, the obtained B-rep graph comprising graph nodes each representing an edge, a face or a co-edge of the B-rep represented by the obtained B-rep graph and being associated with one or more geometrical and/or topological features, where, for each node, the one or more geometrical and/or topological features form a feature vector attached to the node so that the one or more geometrical and/or topological features are also comprised in the obtained B-rep graph, the obtained B-rep graph also comprising graph edges each between a respective first graph node representing a respective co-edge and a respective second graph node representing a face, an edge, an adjacent co-edge, or a mating co-edge associated with the respective co-edge;
   - applying the Deep CAD neural network to the B-rep graph, thereby obtaining a topological signature of the B-rep.

12. A computer program comprising instructions which, when executed on a computer, cause the computer to perform the method of any one of claims 1 to 11.

13. A computer-readable data storage medium having recorded thereon the computer program of claim 12.

14. A computer system comprising a processor coupled to a memory, the memory having recorded thereon the computer program of claim 12.

**Patentansprüche**

1. Computerimplementiertes Verfahren zum maschinellen Lernen, das Verfahren umfassend:

    - Erlangen eines Trainingsdatensatzes von B-rep-Graphen, wobei jeder B-rep-Graph ein entsprechendes B-rep darstellt und umfassend:

       o Graphenknoten, die jeweils eine Kante, eine Fläche oder eine Co-Kante des jeweiligen B-rep darstellen und mit einem oder mehreren geometrischen und/oder topologischen Merkmalen assoziiert sind, wobei für jeden Knoten das eine oder die mehreren geometrischen und/oder topologischen Merkmale einen Merkmalsvektor bilden, der an dem Knoten angelagert ist, sodass das eine oder die mehreren geometrischen und/oder topologischen Merkmale auch in jedem B-rep-Graphen enthalten sind; und
       o Graphenkanten jeweils zwischen einem jeweiligen ersten Graphenknoten, der eine jeweilige Co-Kante darstellt, und einem jeweiligen zweiten Graphenknoten, der eine Fläche, eine Kante, eine angrenzende Co-Kante oder eine zusammenpassende Co-Kante, die mit der jeweiligen Co-Kante assoziiert ist; und

    - Lernen, basierend auf dem Trainingsdatensatz, eines neuronalen Deep-CAD-Netzes, das konfiguriert ist, um als Eingabe einen B-rep-Graphen anzunehmen und eine topologische Signatur des B-rep ausgibt, die durch den eingegebenen B-rep-Graphen dargestellt ist, wobei der B-rep-Graph, der von dem neuronalen Deep-CAD-Netz als Eingang genommen wird, Graphknoten umfasst, die jeweils eine Kante, eine Fläche oder eine Co-Kante des B-rep darstellen, die durch den B-rep-Graphen dargestellt ist, und die mit einem oder mehreren geometrischen und/oder topologischen Merkmalen assoziiert sind, wobei für jeden Knoten das eine oder die mehreren geometrischen und/oder topologischen Merkmale einen Merkmalsvektor bilden, der an den Knoten angelagert ist, sodass das eine oder die mehreren geometrischen und/oder topologischen Merkmale auch in dem B-rep-Graphen enthalten sind, der als Eingang für das neuronale Deep-CAD-Netzwerk genommen wird, der B-rep-Graph, der von dem neuronalen Deep-CAD-Netz als Eingang genommen wird, auch umfassend Graphkanten, jeweils zwischen einem jeweiligen ersten Graphenknoten, der eine jeweilige Co-Kante darstellt, und einem jeweiligen zweiten Graphenknoten, der eine Fläche, eine Kante, eine angrenzende Co-Kante oder eine zusammenpassende Co-Kante, die mit der jeweiligen Co-Kante assoziiert ist, darstellt, wobei das neuronale Deep-CAD-Netz ein tiefes neuronales Netz mit einer konvolutionalen Graphnetzarchitektur ist,

    wobei B-rep Boundary Representation bedeutet und CAD Computer-Aided Design bedeutet.

2. Verfahren nach Anspruch 1, wobei das neuronale Deep-CAD-Netzwerk eine Faltungseinheit umfasst, die konfiguriert ist, um eine Kernverkettung auszuführen, die den Merkmalsvektor jeder Co-Kante mit den Merkmalsvektoren ihrer benachbarten B-rep-Elemente gemäß einem Kern des neuronalen Netzwerks verkettet, wobei die benachbarten B-rep-Elemente der Co-Kante ihre nächste Co-Kante, ihre vorherige Co-Kante, ihre zusammenpassende Co-Kante, ihre Eltern-Kante und ihre Elternfläche sind.

3. Verfahren nach Anspruch 2, wobei die Faltungseinheit ferner konfiguriert ist, um jeden verketteten Merkmalsvektor einer Co-Edge, der aus der Kernverkettung resultiert, als Eingang an ein dichtes neuronales Netz weiterleitet.

4. Verfahren nach Anspruch 3, wobei die Faltungseinheit ferner konfiguriert ist, um für jeden Vektor, der von dem dichten neuronalen Netz für einen eingegebenen verketteten Merkmalsvektor einer Co-Kante ausgegeben wird, einen neuen Kantenmerkmalsvektor, einen neuen Flächenmerkmalsvektor und einen neuen Co-Kantenmerkmalsvektor berechnet.

5. Verfahren nach Anspruch 4, wobei das dichte neuronale Netz für einen verketteten Eingangsmerkmalsvektor $\phi_c^{(i)}$ einer Co-Kante $c$ ausgibt, der sich aus der Kernverkettung ergibt:

$$\psi_c^{(i)} = MLP\left(\phi_c^{(i)}\right) = \left[\ \psi_{CC}^{(i)}\Big|\psi_{CF}^{(i)}\Big|\psi_{CE}^{(i)}\ \right],$$

wobei $\psi_{CC}^{(i)}, \psi_{CF}^{(i)}, \psi_{CE}^{(i)}$ die gleiche Dimension h aufweist, sodass die Dimension von $\psi_c^{(i)}$ 3*h ist, und wobei jede Co-Kante *c*, jede Fläche *F* und jede Kante *E* die neuen Merkmalsvektoren sind,

$$\begin{cases} X_c^{(i+1)} = \psi_{CC}^{(i)} \\ X_E^{(i+1)} = MaxPool(\psi_{CE1}^{(i)}, \psi_{CE2}^{(i)}) \\ X_F^{(i+1)} = MaxPool(\psi_{CF1}^{(i)}, \dots, \psi_{CFk}^{(i)}) \end{cases}$$

wobei

- $X_c^{(i+1)}$ das berechnete neue Co-Kanten-Merkmal für den Ausgang $\psi_c^{(i)}$ des dichten neuronalen Netzes für Co-Kante c ist;

- $X_E^{(i+1)}$ das berechnete neue Kantenmerkmal für Kante *E* ist, wobei $\psi_{CE1}^{(i)}$ und $\psi_{CE2}^{(i)}$ den Merkmalsvektoren seiner zwei assoziierten Co-Kanten entsprechen;

- $X_F^{(i+1)}$ das berechnete neue Flächenmerkmal für Fläche *F* ist, wobei $\psi_{CF1}^{(i)}, \dots, \psi_{CFk}^{(i)}$ den Merkmalen seiner k assoziierten Co-Kanten entsprechen.

6. Verfahren nach Anspruch 2 oder 5, wobei das neuronale Deep-CAD-Netzwerk konfiguriert ist, um die Faltungseinheit eine vorbestimmte Anzahl von Malen wiederholt anzuwenden.

7. Verfahren nach einem der Ansprüche 2 bis 6, wobei das neuronale Deep-CAD-Netz ferner konfiguriert ist, um globale Merkmalsvektoren zu berechnen, indem es eine Aggregation von Flächenmerkmalsvektoren ausführt, wobei die Aggregation auf einem Max-Pooling-Verfahren oder auf einem Attention-Mechanism-Verfahren basiert.

8. Verfahren nach Anspruch 7, wobei das Lernen des neuronalen Deep-CAD-Netzes ein Ausführen eines kontrastiven Lernens umfasst, um das neuronale Deep-CAD-Netz zu trainieren, eine topologische Signatur eines globalen Merkmalsvektors zu berechnen.

9. Verfahren nach Anspruch 8, wobei das kontrastive Lernen auf positiven Transformationen basiert, die Folgendes beinhalten:

   - die Identitätstransformation,
   - Zuordnen einer zufälligen Geometrie zu einer Kante mit einer Wahrscheinlichkeit,
   - Zuordnen einer zufälligen Geometrie zu einer Fläche mit einer Wahrscheinlichkeit,
   - Ersetzen des Merkmalsvektor einer Flächen durch Nullen mit einer bestimmten Wahrscheinlichkeit,
   - Löschen einer Kante mit einer Wahrscheinlichkeit p, wobei diese Löschung nicht angewendet wird, wenn sie eine Fläche von dem Eingangs-B-rep-Graphen abtrennt.

10. Verfahren nach Anspruch 8 oder 9, wobei das kontrastive Lernen ein Minimieren eines normalisierten temperaturskalierten Kreuzentropieverlustes umfasst, der auf der Kosinusähnlichkeit basiert, wobei der Verlust von Folgendem Typ ist:

$$L(i,j) = -\log \frac{e^{sim(Z_i, Z_j)}}{\sum_{k=1}^{2N} \mathbb{1}_{[k \neq i]} e^{sim(Z_i, Z_k)}},$$

wobei (*i,j*) ein positives Paar darstellt und $(Z_i, Z_j)$ eine Einbettung des positiven Paars durch das neuronale Deep-CAD-Netz darstellt, und wobei *sim* die durch die Formel definierte Kosinusähnlichkeit ist:

$$sim(x,y) = \frac{x.y}{\|x\|\|y\|} = \frac{\sum_{i=1}^{h} x_i y_i}{\sqrt{\sum_{i=1}^{h} x_i^2} \sqrt{\sum_{i=1}^{h} y_i^2}},$$

für $x,y \in \mathbb{R}^h$.

11. Verfahren nach einem der Ansprüche 1 bis 10, wobei das Verfahren ferner ein Verwenden des gelernten neuronalen Deep-CAD-Netzwerks umfasst, wobei ein Verwenden des gelernten neuronalen Deep-CAD-Netzwerks umfasst:

- Erlangen eines B-rep-Graphen, der ein B-rep darstellt, der erlangte B-rep-Graph umfassend Graphenknoten, die jeweils eine Kante, eine Fläche oder eine Co-Kante des durch den erlangten B-rep-Graphen repräsentierten B-rep darstellen und mit einem oder mehreren geometrischen und/oder topologischen Merkmalen assoziiert sind, wobei, für jeden Knoten, das eine oder die mehreren geometrischen und/oder topologischen Merkmale einen Merkmalsvektor bilden, der an den Knoten angelagert ist, sodass das eine oder die mehreren geometrischen und/oder topologischen Merkmale auch in dem erlangten B-rep-Graphen enthalten sind, der erlangte B-rep-Graph auch umfassend Graphenkanten jeweils zwischen einem jeweiligen ersten Graphenknoten, der eine jeweilige Co-Kante darstellt, und einem jeweiligen zweiten Graphenknoten, der eine Fläche, eine Kante, eine angrenzende Co-Kante oder eine zusammenpassende Co-Kante, die mit der jeweiligen Co-Kante assoziiert ist;
- Anwenden des neuronalen Deep-CAD-Netzes auf den B-rep-Graphen, wodurch eine topologische Signatur des B-rep erlangt wird.

12. Computerprogramm, umfassend Anweisungen, die, wenn sie auf einem Computer ausgeführt werden, den Computer veranlassen, das Verfahren nach einem der Ansprüche 1 bis 11 durchzuführen.

13. Computerlesbares Datenspeichermedium, in dem das Computerprogramm nach Anspruch 12 aufgezeichnet ist.

14. Computersystem, umfassend einen Prozessor, der mit einem Speicher gekoppelt ist, wobei in dem Speicher das Computerprogramm nach Anspruch 12 aufgezeichnet ist.


**Revendications**

1. Procédé, mis en oeuvre par ordinateur, d'apprentissage automatique, le procédé comprenant les étapes ci-dessous consistant à :

- obtenir un jeu de données d'apprentissage de graphes B-rep, chaque graphe B-rep représentant une représentation B-rep respective et comprenant :

o des noeuds de graphe représentant chacun une arête, une face ou une co-arête de la représentation B-rep respective et étant associés à une ou plusieurs caractéristiques géométriques et/ou topologiques, où, pour chaque noeud, ladite une ou lesdites plusieurs caractéristiques géométriques et/ou topologiques forment un vecteur de caractéristiques rattaché au noeud de sorte que ladite une ou lesdites plusieurs caractéristiques géométriques et/ou topologiques sont également comprises dans ledit graphe B-rep ; et
o des arêtes de graphe chacune entre un premier noeud de graphe respectif représentant une co-arête respective et un deuxième noeud de graphe respectif représentant une face, une arête, une co-arête adjacente ou une co-arête d'accouplement associée à la co-arête respective ; et

- apprendre, sur la base du jeu de données d'apprentissage, un réseau de neurones de conception CAD profond configuré de manière à prendre en entrée un graphe B-rep et à fournir en sortie une signature topologique de la représentation B-rep représentée par le graphe B-rep d'entrée, le graphe B-rep pris en entrée par le réseau de neurones de conception CAD profond comprenant des noeuds de graphe représentant chacun une arête, une face ou une co-arête de la représentation B-rep représentée par le graphe B-rep, et étant associé à une ou plusieurs caractéristiques géométriques et/ou topologiques, où, pour chaque noeud, ladite une ou lesdites plusieurs caractéristiques géométriques et/ou topologiques forment un vecteur de caractéristiques rattaché au noeud de sorte que ladite une ou lesdites plusieurs caractéristiques géométriques et/ou topologiques sont également comprises dans le graphe B-rep pris en entrée par le réseau de neurones de conception CAD profond, le graphe B-rep pris en entrée par le réseau de neurones de conception CAD profond comprenant également des arêtes de graphe chacune entre un premier noeud de graphe respectif représentant une co-arête respective et un deuxième noeud de graphe respectif représentant une face, une arête, une co-arête adjacente, ou une co-arête d'accouplement associée à la co-arête respective, le réseau de neurones de conception CAD profond étant un réseau de neurones profond doté d'une architecture de réseau convolutif de graphe,

dans lequel B-rep signifie « représentation par frontières » et CAD signifie « conception assistée par ordinateur ».

2. Procédé selon la revendication 1, dans lequel le réseau de neurones de conception CAD profond comprend une unité de convolution qui est configurée de manière à mettre en oeuvre une concaténation de noyau qui concatène le vecteur de caractéristiques de chaque co-arête avec les vecteurs de caractéristiques de ses éléments B-rep de voisinage selon un noyau du réseau de neurones, les éléments B-rep de voisinage de la co-arête étant sa co-arête suivante, sa co-arête précédente, sa co-arête d'accouplement, son arête parent et sa face parent.

3. Procédé selon la revendication 2, dans lequel l'unité de convolution est en outre configurée de manière à transmettre chaque vecteur de caractéristiques concaténé d'une co-arête résultant de la concaténation de noyau en tant qu'entrée à un réseau de neurones dense.

4. Procédé selon la revendication 3, dans lequel l'unité de convolution est en outre configurée de manière à calculer, pour chaque vecteur fourni en sortie par le réseau de neurones dense pour un vecteur de caractéristiques concaténé d'entrée d'une co-arête, un nouveau vecteur de caractéristiques d'arête, un nouveau vecteur de caractéristiques de face et un nouveau vecteur de caractéristiques de co-arête.

5. Procédé selon la revendication 4, dans lequel le réseau de neurones dense fournit en sortie, pour un vecteur de caractéristiques concaténé d'entrée $\phi_c{}^{(i)}$ d'une co-arête $c$ résultant de la concaténation de noyau :

$$\psi_c^{(i)} = MLP\left(\phi_c{}^{(i)}\right) = \left[\, \psi_{CC}^{(i)} \,\middle|\, \psi_{CF}^{(i)} \,\middle|\, \psi_{CE}^{(i)} \,\right],$$

où $\psi_{CC}^{(i)}, \psi_{CF}^{(i)}, \psi_{CE}^{(i)}$ ont la même dimension h de sorte que la dimension de $\psi_c^{(i)}$ est 3*h, et dans lequel, pour chaque co-arête $c$, chaque face $F$ et chaque arête $E$, les nouveaux vecteurs de caractéristiques sont,

$$\begin{cases} X_c^{(i+1)} = \psi_{CC}^{(i)} \\ X_E^{(i+1)} = MaxPool(\psi_{CE1}^{(i)}, \psi_{CE2}^{(i)}) \\ X_F^{(i+1)} = MaxPool(\psi_{CF1}^{(i)}, \dots, \psi_{CFk}^{(i)}) \end{cases}$$

où :

- $X_c^{(i+1)}$ est la nouvelle caractéristique de co-arête calculée pour la sortie $\psi_c^{(i)}$ du réseau de neurones dense pour la co-arête $c$ ;
- $X_E^{(i+1)}$ est la nouvelle caractéristique d'arête calculée pour l'arête $E$, où $\psi_{CE1}^{(i)}$ et $\psi_{CE2}^{(i)}$ correspondent aux vecteurs de caractéristiques de ses deux co-arêtes associées ;
- $X_F^{(i+1)}$ est la nouvelle caractéristique de face calculée pour la face $F$, où $\psi_{CF1}^{(i)}, \dots, \psi_{CFk}^{(i)}$ correspondent aux caractéristiques de ses $k$ co-arêtes associées.

6. Procédé selon la revendication 2 ou 5, dans lequel le réseau de neurones de conception CAD profond est configuré de manière à appliquer l'unité de convolution de manière répétée un nombre de fois prédéterminé.

7. Procédé selon l'une quelconque des revendications 2 à 6, dans lequel le réseau de neurones de conception CAD profond est en outre configuré de manière à calculer des vecteurs de caractéristiques globaux en mettant en oeuvre une agrégation de vecteurs de caractéristiques de face, l'agrégation étant basée sur un procédé de max pooling ou sur un procédé de mécanisme d'attention.

8. Procédé selon la revendication 7, dans lequel l'étape d'apprentissage du réseau de neurones de conception CAD profond comprend l'étape consistant à mettre en oeuvre un apprentissage contrastif pour entraîner le réseau de neurones de conception CAD profond à calculer une signature topologique d'un vecteur de caractéristiques global.

9. Procédé selon la revendication 8, dans lequel l'apprentissage contrastif est basé sur des transformations positives qui incluent :

- la transformation d'identité ;
- affecter une géométrie aléatoire à une arête avec une probabilité ;
- affecter une géométrie aléatoire à une face avec une probabilité ;
- remplacer le vecteur de caractéristiques d'une face par des zéros avec une probabilité ; et
- supprimer une arête avec une probabilité p, cette suppression n'étant pas appliquée si elle déconnecte une face du graphe B-rep d'entrée.

10. Procédé selon la revendication 8 ou 9, dans lequel l'apprentissage contrastif comprend l'étape de minimisation d'une perte d'entropie croisée à température mise à l'échelle normalisée qui est basée sur la similarité cosinusoïdale, la perte étant du type :

$$L(i,j) = -\log \frac{e^{sim(z_i, z_j)}}{\sum_{k=1}^{2N} 1_{[k \neq i]} e^{sim(z_i, z_k)}},$$

où ($i$, $j$) représente une paire positive et ($z_i$, $z_j$) représente une intégration de la paire positive par le réseau de neurones de conception CAD profond, et où « $sim$ » est la similarité cosinusoïdale définie par la formule :

$$sim(x,y) = \frac{x.y}{\|x\|\|y\|} = \frac{\sum_{i=1}^{h} x_i y_i}{\sqrt{\sum_{i=1}^{h} x_i^2} \sqrt{\sum_{i=1}^{h} y_i^2}},$$

$x, y \in \mathbb{R}^h$.
pour                .

11. Procédé selon l'une quelconque des revendications 1 à 10, dans lequel le procédé comprend en outre l'étape d'utilisation du réseau de neurones de conception CAD profond appris, dans lequel l'étape d'utilisation du réseau de neurones de conception CAD profond appris comprend les étapes ci-dessous consistant à :

- obtenir un graphe B-rep représentant une représentation B-rep, le graphe B-rep obtenu comprenant des noeuds de graphe représentant chacun une arête, une face ou une co-arête de la représentation B-rep représentée par le graphe B-rep obtenu et étant associé à une ou plusieurs caractéristiques géométriques et/ou topologiques, où, pour chaque noeud, ladite une ou lesdites plusieurs caractéristiques géométriques et/ou topologiques forment un vecteur de caractéristiques rattaché au noeud, de sorte que ladite une ou lesdites plusieurs caractéristiques géométriques et/ou topologiques sont également comprises dans le graphe B-rep obtenu, le graphe B-rep obtenu comprenant également des arêtes de graphe chacune entre un premier noeud de graphe respectif, représentant une co-arête respective, et un deuxième noeud de graphe respectif, représentant une face, une arête, une co-arête adjacente, ou une co-arête d'accouplement associée à la co-arête respective ;
- appliquer le réseau de neurones de conception CAD profond au graphe B-rep, ce qui permet d'obtenir par conséquent une signature topologique de la représentation B-rep.

**12.** Programme informatique comprenant des instructions qui, lorsqu'elles sont exécutées sur un ordinateur, amènent l'ordinateur à mettre en oeuvre le procédé selon l'une quelconque des revendications 1 à 11.

**13.** Support de stockage de données lisible par ordinateur sur lequel est enregistré le programme informatique selon la revendication 12.

**14.** Système informatique comprenant un processeur couplé à une mémoire, sur laquelle mémoire est enregistré le programme informatique selon la revendication 12.

# FIG. 1

FIG. 2

FIG. 3

FIG. 4

## FIG. 5

FIG. 6

Input | Most similar objects from industrial equipment dataset (top 3) and Solid Letters dataset (bottom 3)

# FIG. 7

Offline learning

Training BRep files → DNN model learning

Online learning

Input BRep file

BRep database

→ Apply learned DNN model → Most topologically similar BRep objects from BRep database to the Input BRep

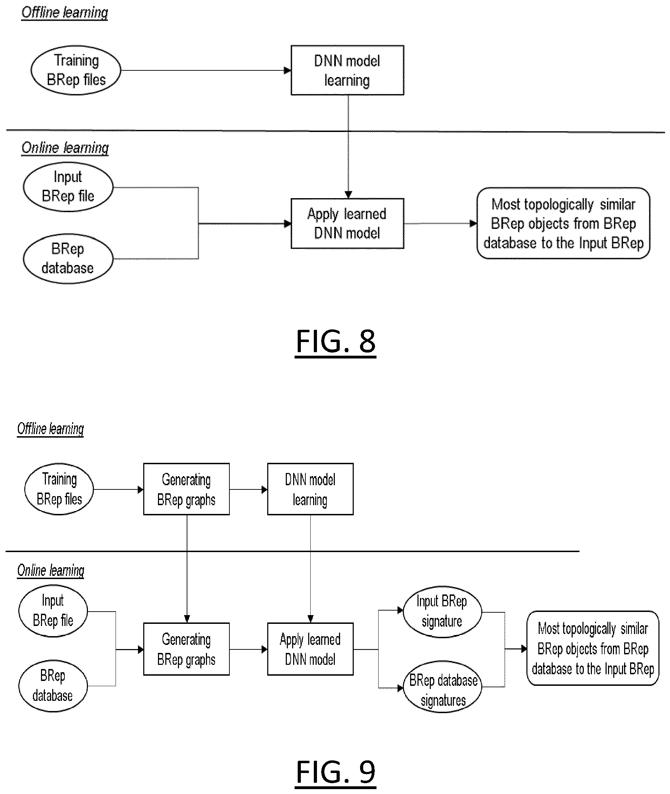

## FIG. 8

Offline learning

Training BRep files → Generating BRep graphs → DNN model learning

Online learning

Input BRep file

BRep database

→ Generating BRep graphs → Apply learned DNN model →

Input BRep signature

BRep database signatures

→ Most topologically similar BRep objects from BRep database to the Input BRep

## FIG. 9

Query          Closest (geometrically)          Closest (topologically)

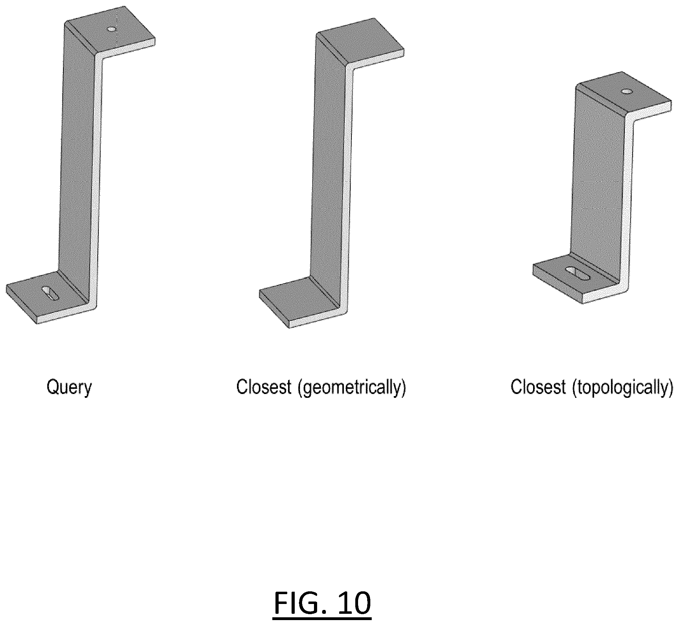

# FIG. 10

Query    Closest (geometrically)    Closest (topologically)

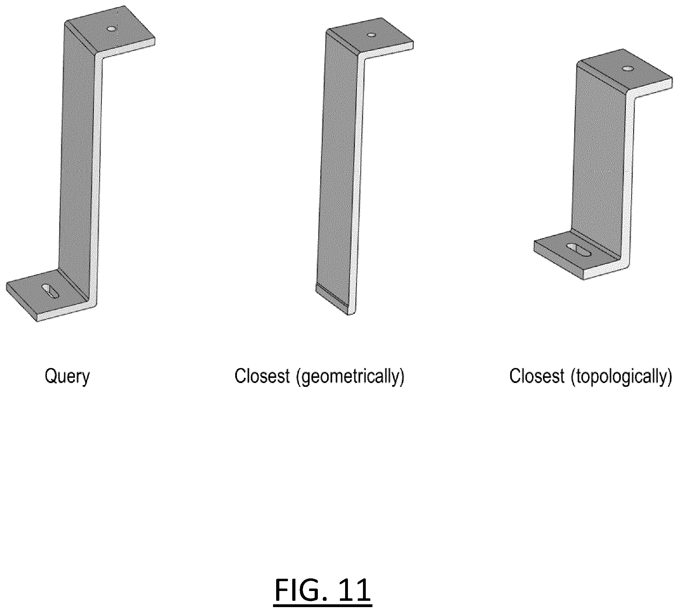

# FIG. 11

Query          Closest (geometrically)          Closest (topologically)

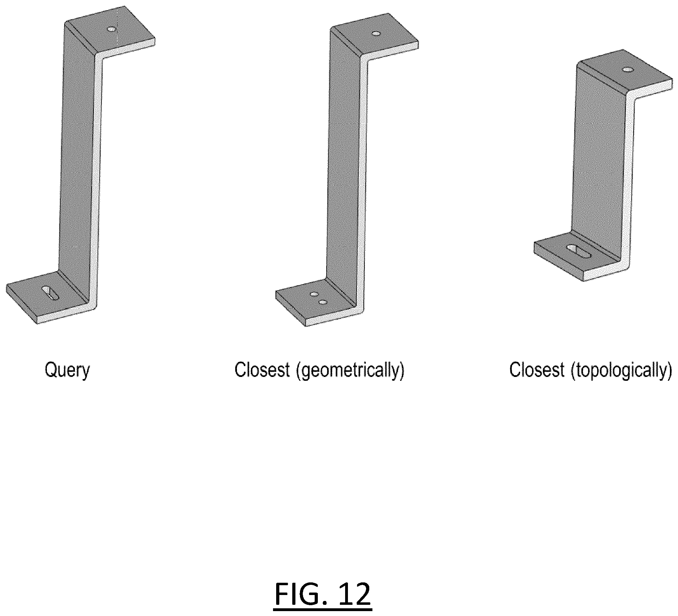

# FIG. 12

Query                Closest (geometrically)        Closest (topologically)

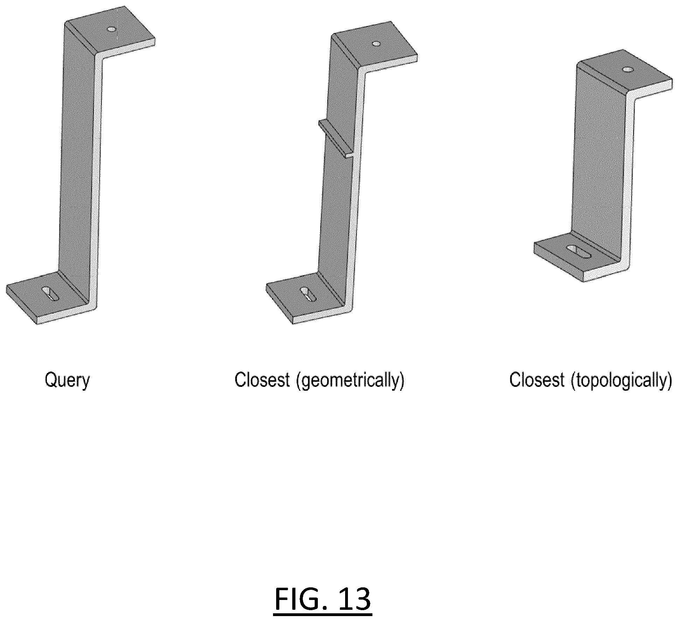

# FIG. 13

FIG. 14

## REFERENCES CITED IN THE DESCRIPTION

**Non-patent literature cited in the description**

- **P. K. JAYARAMAN.** UV-Net: Learning from Boundary Representations. *2021 IEEE/CVF Conference on Computer Vision and Pattern Recognition (CVPR)*
- **T. FUNKHOUSER.** *Shape-Based Retrieval and Analysis of 3D Models,* 2004
- foundations. **D. E. RUMELHART ; G. E. HINTON ; R. J. WILLIAMS.** Learning internal representations by error propagation, Parallel distributed processing: explorations in the microstructure of cognition. MIT Press, 1986, vol. 1

- **T. N. KIPF ; M. WELLING.** *Semi-Supervised Classification with Graph Convolutional Networks,* 2016
- **M. ILSE ; J. M. TOMCZAK ; M. WELLING.** *Attention-based Deep Multiple Instance Learning,* 2018
- **T. CHEN ; S. KORNBLITH ; M. NOROUZI ; G. E. HINTON.** *A Simple Framework for Contrastive Learning of Visual Representations,* 2020
- **P. K. JAYARAMAN ; A. SANGHI ; J. G. LAMBOURNE ; K. D. WILLIS ; T. DAVIES ; H. SHAYANI ; N. MORRIS.** UV-Net: Learning from Boundary Representations. *CVPR,* 2021